# EUROPEAN PATENT APPLICATION

(11) **EP 2 711 978 A1**
(43) Date of publication of application: **26.03.2014**
(21) Application number: 12185755.1
(22) Date of filing: 24.09.2012
(51) Int. Cl.: H01L 21/67, B28D 5/00, B28D 5/04

(54) **Method of making wafers**

(71) Applicant: Meyer Burger AG, 3645 GWATT (Thun) (CH)
(72) Inventor: Habegger, Simon, 3612 Steffisburg (CH); Wiedmer, Frederic, 3007 Bern (CH)
(74) Representative: Patentbüro Paul Rosenich AG

(57) **Abstract**

The invention relates to a method of making wafers (5) from an ingot (4), the method comprising:
- a step of cutting the ingot (4) into a plurality of wafers (5) in a wire saw (2),
- a step of receiving the wafers (5) by a wafer receiving box (3) during or subsequent to the step of cutting,
- a step of transporting (22) the wafers (5) by means of the wafer receiving box (3) to at least one processing station (12, 13, 14, 15) which is arranged outside of the wire saw (2),
- at least one wafer processing step which is performed in said processing station (12, 13, 14, 15),
characterized in that
during the step of transporting (22) the wafers (5) to said processing station () the wafer receiving box (3) is at least partially filled with fluid, wherein the wafers (5) are at least partially, preferably completely, immersed in said fluid.

## Description

The invention refers to a method of making wafers from an ingot or brick, the method comprising:
- a step of cutting the ingot into a plurality of wafers in a wire saw,
- a step of receiving the wafers by a wafer receiving box during or subsequent to the step of cutting,
- a step of transporting the wafers by means of the wafer receiving box to at least one wafer processing station which is arranged outside of the wire saw,
- at least one wafer processing step which is performed in said wafer processing station.

Wafers e.g. for use in solar cells are cut from a block (also called brick or ingot) in a wire cutting device employing a metal wire and abrasives. Usually abrasives suspended in a slurry, that are transported by a metal wire, are used. Nowadays, wafers are cut more and more using fixed abrasives, which are directly attached to the metal wire. Such wire is e.g. called a diamond wire. The present invention is not restricted to one of these cutting technologies.

The ingot to be cut is of poly-crystalline or mono-crystalline semiconductor material, e.g. silicon or other materials such as sapphire. In the latter case, the ingot is generally referred to as core. The ingot is what is casted. In the case of a poly-crystalline material, usually a large ingot is casted and bricks are cut from that. In case of a mono-crystalline material normally a round ingot is made and cut into the typical mono-crystalline wafer shape. Ingot as used in this application means both the ingot as casted and the brick that is made from the ingot to be cut. Moreover, the ingot as used in this application means the material to be cut.

From prior art containers are known for receiving a wafer already cut into a plurality of individual wafers. When the wafers are still basically in the position they were in before they were cut, the wafers are called a wafer block or wafer brick. The containers are used to clean or otherwise treat the wafers.

Prior art is further known, where the block to be cut is attached to a glass plate, which in turn is attached to a fixture attachment. The fixture attachment is horizontally inserted between two guide rails (usually L-shaped). The guide rails are part of the cutting device and only used for inserting the workpiece into the machine. As soon as the workpiece is in position, clamps hold the fixture attachment during cutting. When the cutting process is finished, the wafer block (arrangement of a plurality of parallel wafers) is slid out of the cutting device, while the fixture attachment is supported by the two guide rails.

Due to the fact, that the load is pretty heavy, the relative motion of the guide rails, the fixture attachment and the dirt (slurry) in between produces friction that is irregular and pretty hard to overcome. Moreover, when moving the block into and out of the cutting device or during transportation, the block wobbles (e.g. slip-stick effect). In the case of the inward movement this does not constitute a problem, since the block has not been cut yet. However, when removing said wafer block comprising a plurality of extremely thin wafers, the so called slip-stick effect causes damages to the wafers. The individual wafers tilt easily about the axis formed by the thin attachment zone on the glass plate or the fixture attachment, respectively. This causes adjacent wafers to touch each other. When the wafers however touch each other they may be damaged. Hence the slip-stick effect causes yield loss, resulting in higher costs per wafer.

Wafer carriers for wafers for solar cells are known from the state of the art. They often have (movable) means for holding the wafers, e.g. CN201788957U, DE102005028112A, DE102006052908A, DE102008060012 A1, DE102008060014 A1, DE102008062123 A1, DE102008060012 A1, JP10181880 A and WO2008106913 A2.

JP5220731A discloses a wafer cutting and separating method, wherein the cutting wire of a wire saw cuts in a horizontal manner when it has reached the beam. The separated wafers are received by wafer receiving box.

JP7153724A discloses that the wafers cut from an ingot are received by a cassette after the step of cutting. The distance between the wire guide rollers of the corresponding wire saw is very large such that the cutting quality is adversely effected.

PCT/EP2011/064621 discloses a loading device which is used to move the work piece holder with attached brick and wafer brick in and out of the wire saw, respectively.

Following parameters are a measure for the quality of the wafers:
- Thickness, TTV (Total Thickness Variation = difference of the maximum thickness value and the minimum thickness value of silicon wafers)
- Saw marks (saw marks = grooves on the wafer surfaces, which are generated during the sawing process by a wire saw)
- Sori, Bow (sori = waviness of the wafer surface, bow = difference of the highest point of one wafer surface to the lowest one of the same wafer surface).

Also know from prior art is to do the de-gluing in the wire saw and take out the wafers from between the wire guide rollers, e.g. JP7153724 A.

Other prior art documents relate to the wafer cutting process, wherein the wafers or the cut material is immersed in fluid during the cutting step, e.g. US2012085333A1, CH696389A5, DE10157433 A1. From EP1437209 B1 it is known to partially immerse the wafers in a thick liquid or gel.

Further documents EP2110216A1, JP5220731A and US7284548B2 refer to the cutting process as such.

According to other prior art, the wafer block is removed from the wire saw and placed in a wafer carrier. The wafer carrier is transported to the next stages in the process. Normally this process consists of the following steps: Sawing, pre-cleaning/de-gluing, wafer separation, final wafer cleaning, (solar) cell manufacturing.

During the wafer pre-cleaning and de-gluing steps coarse dirt is removed from the wafers and the wafers are detached from the beam, respectively. After pre-cleaning and de-gluing, the wafers are normally stacked (horizontally or vertically). In a wafer separation (=singulation) step, the wafers are separated from each other for further individual treatment. The now singulated wafers are cleaned to a degree that they can be processed chemically to be turned into e.g. a solar cell.

The problem that arises in prior art systems is that the wafers which are covered by slurry or cutting fluid and dirt begin to dry up after the cutting step. This has the adverse effect that slurry, dirt, particles, swarf, etc. sticks on and even bond with the wafer surfaces, that neighboring wafers stick together or may directly collide with each other if there is for example an acceleration force applied during movement. This may damage the wafers during transport and/or during separation, since a force has to applied in order to counteract the sticking force between two wafers. Wafer quality thus decreases and so does the efficiency of solar cells.

The object of the present invention is to overcome these problems and to provide a method of obtaining high quality wafers and facilitate further treatment by keeping the wafers as clean as possible and away from reactive components, from cutting as well as from the air (oxygen). The transport of the wafers from the wire saw to other processing stations should be performed gently, without the risk of damaging the wafers. The handling of the wafers should be uncomplicated and cost-effective.

This object is achieved by a method of making wafers as mentioned above wherein during the step of transporting the wafers to said wafer processing station the wafer receiving box is at least partially filled with fluid, wherein the wafers are at least partially, preferably completely, immersed in said fluid.

Due to the fact that the wafers are immersed in the fluid during their transport they will not dry up and the adverse effects of sticking arising in prior art are overcome. They are also protected from oxygen. The fluid film between the wafers prevents that slurry, dirt, swarf, etc. sticks to the wafer surfaces and/or that the wafers stick together. Further, the fluid acts as an damper which attenuates vibrations, mechanical impacts and acceleration forces during the handling and/or transport. The wafer receiving box by means of which the transport to the processing station is performed has a transport function and may be also denoted as transport wafer receiving box. Preferably, the wafers are completely immersed in fluid during the step of transporting.

If the wafers are not directly received by the wafer receiving box during the cutting step, the wafers may be received by the wafer receiving box immediately subsequent to the cutting step, such that the wafers are kept wet and have no time to dry so. This also prevents that the particles in the fluid/components of the cutting fluid itself do not attach themselves to the wafers.

If the wafers are not (completely) received in the wafer receiving box during the cutting step (but at a later stage), means may be provided in the wire saw to keep them wet, e.g. fluid nozzles.

The wafers are now completely protected from adverse influences. This also means that in a preferred embodiment the wafers may be stored in the fluid of the wafer receiving box before being further processed. Preferably the wafers are stored for more than 5 minutes, more preferably more than an hour, or even several hours or days. This allows to interrupt the manufacturing process without the risk of diminishing wafer quality.

During storage, the wafer receiving box may be hooked up to a supply of fluid, making a fluid flow within the box to at least partially clean the wafers.

According to the invention the wafer receiving box which is also used for transporting the wafers to a wafer processing station has a reservoir for fluid. The fluid in the receiving box may be e.g. cutting fluid for submerging the wafers during and after cutting.

The advantage of not letting the wafers dry is that the silicon particles and cutting fluid/slurry do not stick to the wafers while drying up.

Also the wafers do not build groups as easily. Groups are formed because of attractive forces acting between wafers. If the wafers are submerged, adhesive forces do not play an important role because they work on the wafers symmetrically. Grouping makes it harder to separate the wafers. Also the pre-cleaning is impaired: if two wafers stick together it is virtually impossible to clean their touching surfaces.

The wafer receiving box is removed from the wire saw subsequent to the cutting step and may be placed on a transport wagon. A wafer separating station may be used to individually lay the wafers on a conveyor belt.

The transport is performed slowly in order not to lose the fluid. Transport means for transporting the wafer receiving box during the step of transporting may be a carriage or wagon, conveyor belt, a crane, a cableway, etc..

The inventive wafer receiving box for receiving and transporting wafers has a reservoir for holding a liquid for at least partially, preferably completely submerging wafers during and/or subsequent to the cutting step and when transporting the wafers to the next processing station.

Preferably, already the (partially cut) wafers are submerged during cutting, keeping them submerged during any of de-gluing, pre-cleaning, transporting to the next processing station or any combination thereof.

A further preferred goal is to be able to place the box in the separation station so that the wafers do not leave the box and thus the fluid before they are separated and or (subsequently) cleaned completely.

The wafers are at least partially held inside the reservoir. The wafers being held in the reservoir by holding means. Another advantage is that the wafers can be efficiently and securely cleaned inside the wire saw, because they are held.

The next step (where the wafers are removed from the fluid) is at least any of a separation (singulation) step, final cleaning and or a texturization step (e.g. for pyramid building for better low-reflective properties).

Wafers may have been cleaned and de-glued when they leave the wire saw and reach a cleaning station. The cleaning may be done by generating a macroscopic fluid flow in the reservoir.

The sawing wire of the wire saw (or actually the lowest wire on the wire web) is kept at a predetermined distance above the wafer receiving box and/or the fluid level in the box so that the fluid in the reservoir does not impair wafer cutting.

The fluid may be used to maintain the temperature of the wafers and the not yet cut brick at a predetermined level. The good thermal conductivity of the silicon enables cooling or warming even though the wafers are only partially immerged.

Preferably, the wafers remain in the fluid until they are separated and/or cleaned. Finally, the box with the submerged wafers is placed in a separator and the wafers are automatically handled from there. Moreover, no direct human interaction with individual wafers and preferably neither with the carrier is required in an aspect of the invention and the wafers do not leave the fluid until being cleaned or separated.

Further processing stations may be a (pre-)cleaning station, a de-gluing station (note that there are other systems to retrieve the wafers from between the wire webs that need to be de-glued. Such systems may cut the beam (US7284548B2, JP5220731) or may have a beam that splits), a separating station where wafers are released from the wafer block and/or other wafers. All may be done by hand or may be (at least partially) automated.

Preferably, during the step of cutting the wafers, the wafer receiving box is removably held or removably attached in the wire saw such that the wafers are received by the wafer receiving box during the step of cutting. This allows a simple uncomplicated handling, because the wafers are protected by the wafer receiving box and the fluid inside immediately after their cut. It is not necessary to retrieve the wafers through the wire web. They are directly accommodated in the receiving box, which is removable from the wire saw. The transport to further processing stations is performed by means of that wafer receiving box. Normally the wafer carried box is placed and secured in the machine prior to cutting. As soon as the wafers need to be removed from the wire saw, the wafer box is disengaged and taken from the wire saw. Removably as used here means that the wafer box is temporary (during cutting) part of the wire saw and easily removed by the operator as part of normal daily routine. Means may be provided for easily attaching and detaching the wafer box by hand or (semi-) automatically.

Preferably, during the step of cutting the wafers, the wafer receiving box is at least partially filled with said fluid such that the wafers are immersed in said fluid during the step of cutting. The fluid protects the wafers already during the step of cutting. Preferably the distance from the (lowest) cutting wire to the surface of the fluid is kept as small as possible, not impairing cutting quality because of the interaction between the fluid in the wafer carrier and the cutting wire of the fluid on that wire used for cutting. This fluid may be a cutting fluid, another fluid than used for cutting or unused (and thus clean) cutting fluid that may later be used for cutting.

Preferably, the wafers are kept immersed in said fluid at least until the processing step is started in said processing station. The protection by the fluid is kept upright as long as possible.

Preferably, during and/or subsequent to the step of cutting, a fluid flow is generated in said fluid of the wafer receiving box, preferably when the wafer receiving box is still inserted in the wire saw and/or during storage of the wafers in the wafer receiving box prior to a wafer processing step. This allows a pre-cleaning step during which particles generated during the cutting process can be removed from the wafers. During the cutting process the fluid may also act a cooling medium.

Preferably, the fluid net flow has a component which is transverse with respect to the moving direction of the ingot through the wire web of the wire saw during the step of cutting. This allows an efficient removal of particles from the wafers. The flow may also have a turbulent component.

Preferably, the fluid net flow is generated at least at the bottom of the wafer receiving box. In this embodiment the heavy particles settling down may be removed from the wafer receiving box.

Preferably, the fluid net flow is generated as to flow in the gaps between the wafers. In such a way also the gaps may be rid of dirt.

Preferably, the wafer receiving box has an inlet for introducing a fluid into the wafer receiving box and wherein the fluid flow is generated by introducing fluid through the inlet to the wafer receiving box and wherein preferably the inlet is arranged in a side wall of the wafer receiving box. This allows a flexible handling, since the inlet can be connected to a fluid supply in any processing station. During transport the inlet may be closed, e.g. by a valve.

Preferably, the wafer receiving box has an closable outlet for removing the fluid from the wafer receiving box and wherein preferably the outlet is arranged in a side wall or in the bottom wall of the wafer receiving box. In this embodiment the fluid can be removed together with the dirt, particles, swarf, etc. without the need of taking out the wafers from the box.

Preferably, the bottom of the wafer receiving box, at least when inserted in the wire saw, is inclined with respect to the horizontal. This facilitates the removal and/or concentration of dirt, particles, swarf, etc., since the gravitational force concentrates them in the lowest region of the bottom. It was found that if the bottom of the reservoir has a sloop and the fluid flows downward over this sloop, the swarf is removed from the wafers and the reservoir effectively.

Preferably, the bottom of the wafer receiving box is inclined in a direction perpendicular to the wire of the wire web (or parallel to the axes of the wire guide rollers supporting the wire web).

Preferably, the inlet for introducing a fluid into the wafer receiving box and the outlet for removing the fluid from the wafer receiving box are located in the bottom region of the wafer receiving box. A concentrated and well defined net fluid flow can be established in the bottom region of the box.

Preferably, the wafers as such are cleaned by means of a fluid coming through channels in the beam.

An inlet for (cleaning) fluid can be used near the top so that the fluid flows past the cut part of the wafers and/or near the bottom to remove swarf effectively. The fluid supplied to the reservoir may also come from the cutting process. The fluid may also flow over the edges of the reservoir to ensure that the reservoir does not get empty. The reservoir may also be filled by fluid from the cutting process.

Also other means for facilitating the flow over the wafers and transport of swarf/silicon particles and splitter out of the container may be provided. Preferably, the fluid in the wafer receiving box is alkaline, preferably having a pH-value of pH > 7, preferably pH > 8, most preferably pH > 9, so that silicon splitters/swarf does not attach themselves to the wafers.

Preferably, the wafer receiving box comprises a clamping mechanism and wherein the wafers are clamped by the clamping mechanism during the step of transporting. The clamping of the wafers protects them from striking to each other, rocking movement/flow in the fluid and/or vibrations.

Preferably, the processing station is selected from the group consisting of a wafer pre-cleaning station, a wafer cleaning station, a wafer de-gluing station for de-gluing the wafers from the beam or removing glue from the wafers, and a wafer separating station, a wafer texturization station for texturizing the surface of the wafers, or any combination thereof.

Preferably, the method comprises at least two wafer processing steps each being performed in a separate processing station and wherein one of the wafer processing steps is a separating step for separating the wafers from each other and wherein the wafers are kept immersed in said fluid at least until the separating step is started. In a preferred embodiment the wafers are kept at least partially submerged until they are separated in a separation (singulation) station, so that they do not dry up at any time.

Preferably, during the step of cutting the wafers are received within the wire saw by an intermediate wafer receiving box and the method comprises subsequent to the step of cutting a step of transferring the wafers from the intermediate wafer receiving box to the wafer receiving box by means of which the step of transporting the wafers to at least one wafer processing station is performed, wherein preferably the intermediate wafer receiving box is filled with fluid. This allows to use two boxes for different functions: the intermediate wafer receiving box for receiving and protecting the wafers during the step of cutting; and the (transport) wafer receiving box for transporting the wafers, keeping them wet and protecting them. Also the intermediate wafer receiving box may stay attached to the wire saw, thus omitting any alignment problems of the box relative to the wire saw. Also the intermediate wafer receiving box will be very dirty because it is in the wire saw during cutting. Since the (transport) wafer receiving box by means of which the step of transporting the wafers to at least one wafer processing station is performed may be kept clean, the spread of dirt can be prevented this way.

Preferably, prior to the step of transferring the wafers from the intermediate box to the wafer receiving box, the intermediate wafer receiving box is moved outside of the wire saw, wherein preferably the intermediate wafer receiving box is movably mounted to the wire saw, preferably as a drawer e.g. with a (telescopic) rail guidance. This allows the handling to become more convenient, since the step of transferring can be performed outside the wire saw and no alignment is needed when inserting the intermediate wafer receiving box back into the wire saw.

Preferably, from the point at which the wafers are completely cut through to the point at which the wafers reach the processing station, the wafers are no longer extracted from fluid than one minute, preferably no longer than 30 seconds, more preferably no longer than 10 seconds. The rest of the time the wafers are completely immersed in fluid such that they stay wet.

Further embodiments of the invention are indicated in the figures and in the dependent claims. The list of reference marks forms part of the disclosure. The invention will now be explained in detail by the drawings. In the drawings:
Fig. 1 shows a wire saw for cutting a plurality of wafers from an ingot,
Fig. 2 shows a wafer making system comprising a wire saw and a wafer processing station,
Fig. 3 shows the step of transporting the wafers in the wafer receiving box to a wafer processing station,
Fig. 4 shows a wafer making system comprising a wire saw and a plurality wafer processing stations,
Fig. 5 shows an embodiment of a wafer receiving box inserted in a wire saw,
Fig. 6, 7 and 8 show embodiments of the inventive method.

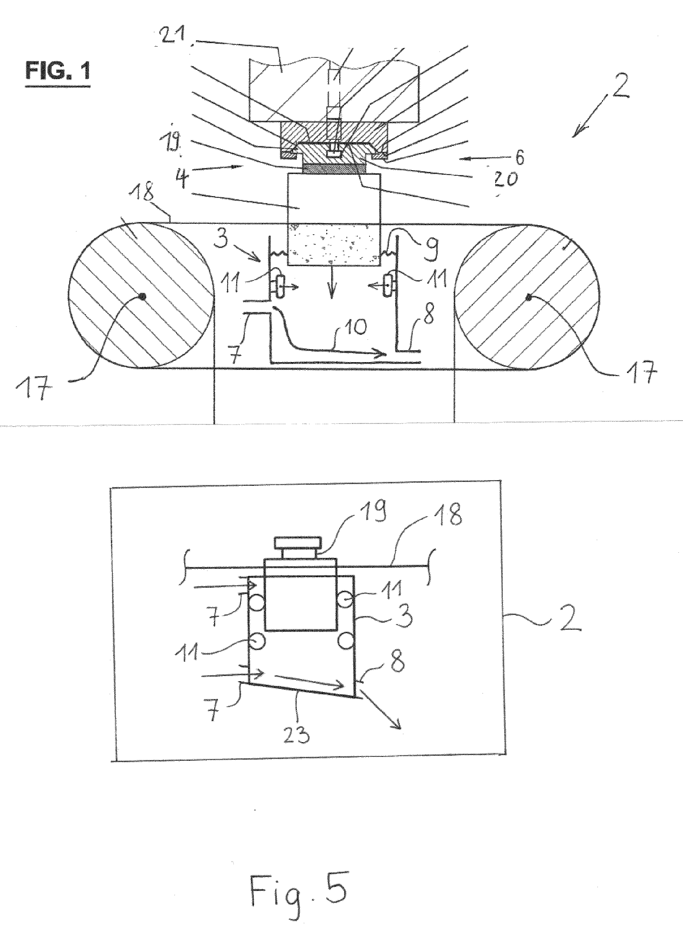

Fig. 1 shows a wire saw 2 for cutting a plurality of wafers from an ingot 4 (also called brick or core). The wire saw 2 comprises a support base 21 for positioning ingot 4 with respect to a wire web 18 which is formed by a cutting wire. Ingot 4 is glued to a beam 19 (also called sacrificial substrate), which in turn is attached to a fixture attachment 20 usually made of metal. The beam 19 is mounted to the fixture attachment 20 which in turn is detachably mounted to the support base 21 of the wire saw 2.

Wire saw 2 further comprises wire guide rollers 17 for forming a field of cutting wire, i.e. wire web 18. Note that the wires of the wire web are shown in one plane. Since the progress of the wires in the brick differs for each wire, the wires normally do not lay in one plane during cutting.

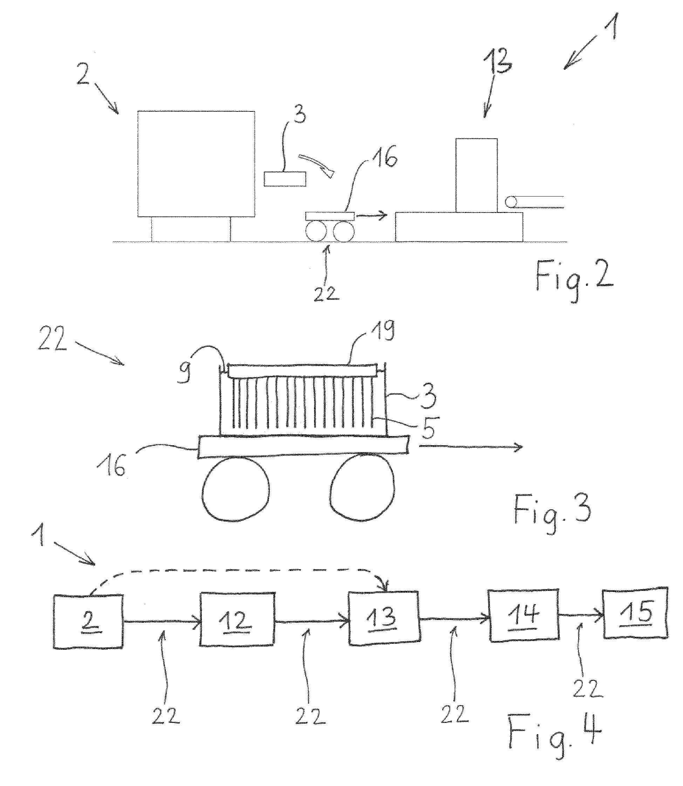

After all cuts for separating the wavers 5 have been made (all wafers are cut in parallel), the wafers 5 are still attached to the beam 19 giving the wafer block a comb-like structure (as can be seen from Fig. 3).

During the cutting process, the ingot 4 is pushed through the wire web 18, causing the cutting wire to bend downwards (not shown). Because of this bow of the cutting wire and the different cutting speed of the individual wire segments, the top edges of the ingot are cut before the middle part of the ingot is completely cut. It is the purpose of the sacrificial substrate or beam 19 to keep the fixture attachment 20 at a distance of the ingot 4, so that the fixture attachment 20 is not cut. The beam 19 - which is relatively inexpensive - is replaced after each cut.

Once the wafers 5 have been cut, they have to be cleaned and separated from the beam 19. Ideally, all wafers 5 are aligned in parallel with a constant spacing between the individual wafers. However, the wafers 5 are very thin and easily damaged. One can imagine, that if the fixture attachment 20 is tilted or pushed, the wafers move sideward and stick to each other due to the fluid on their respective surfaces forming the spacing between them.

After the ingot 4 has been cut, the wafers 5 are dirty from the slurry or cutting fluid and the silicon particles that are cut off (swarf). If the wafers are left to dry, the swarf gets stuck to the wafers are very hard to remove. Also the wafers become stains that are not allowable.

Fig. 2 shows a wafer making system 1 according to the present invention. The wafer making system 1 comprises a wire saw 2. The wafer making system 1 further comprises a wafer receiving box 3 to be temporarily inserted in the wire saw 2 for receiving the wafers 5 during the cutting step. As can be seen from Fig. 1, box 3 is dimensioned such that it fits below the wire web 18 and between the wire guide rollers 17. Box 3 is built up by a bottom plate and side walls 7 extending from said bottom plate.

It is not necessary for the invention that the wafer receiving box is inserted in the wire saw and that the wafers are directly received during cutting. It would be also possible to submerge the cut wafers immediately after the cutting step in a fluid-filled wafer receiving box. This could be done e.g. in or in front of the wire saw 2 as well. In that case it is beneficial if the wire saw has means for keeping the wafers wet during cutting and or before being removed from the wire saw such as e.g. a non-removable reservoir for receiving the wafers or nozzles for fluid.

The method of making wafers 5 from an ingot 4 is now described in detail with respect to Figs. 2 to 4. In a first step the ingot 4 is cut to a plurality of wafers in a wire saw. During the step of cutting or immediately subsequent to the step of cutting, the wafers 5 are received by a wafer receiving box 3. In the embodiment of Fig. 1 the wafer receiving box 3 is removably inserted in the wire saw 2 (e.g. by means of slides or guidance rails) during the step of cutting, such that the wafers 5 are received by the wafer receiving box 3 during the step of cutting. The wafer receiving box 3 is at least partially filled with fluid 9 such that the wafers 5 are immersed in said fluid 9 during the step of cutting.

The wafer receiving box 3 may be removed from the wire saw 2 by a movement essentially parallel to the rotational axes of the wire guide rollers 17. In a further step, the wafers 5 are transported 22 by means of the wafer receiving box 3 to at least one wafer processing station 12, 13, 14, 15 which is arranged outside of and distanced from the wire saw 2. As can be seen from Fig. 2 and 3 the transport means used is a carriage 16. During the step of transporting 22, the wafers 5 to said processing station 12, 13, 14, 15 the wafers 5 are immersed in the fluid 9 of the wafer receiving box 3 (Fig. 3). In the wafer processing station at least one wafer processing step is performed.

In the embodiment of Fig. 2, the wafer processing station is a wafer cleaning station 13. Alternatively, the processing station may be a wafer pre-cleaning station, a wafer de-gluing station for de-gluing the wafers 5 from the beam 19 or removing glue from the wafers 5, and a wafer separating station 15. In the embodiment of Fig. 4, several wafer processing stations (pre-cleaning station 12, cleaning station 13, de-gluing station 14 and separating station 15) are provided, wherein the wafers 5 are sequentially transported from one processing station to another processing station. Preferably, the wafers 5 are kept immersed in the fluid 9 of the wafer receiving box 3 until they reach the separating station 15. The sequential order of the wafer processing stations 12, 13, 14, 15 as depicted in Fig. 4 is only one possibility of a wafer making system 1. Any other order would be possible and is in the scope of the present invention. Also any number of stations may be omitted, as indicated in Fig. 4 by the dashed arrow. In other embodiments the order of the cleaning-, de-gluing- and/or separation station may be reversed. Some of them may be omitted and/or other kind of wafer processing stations may be provided as well. The wafers 5 are kept immersed in said fluid 9 at least until the processing step is started in each processing station 12, 13, 14, 15, preferably until the wafers 5 have reached the separating (singulation) station 15, form where they are transported e.g. by means by a conveyor (belt) to further stations.

The wafer receiving box 3 as a whole may be placed in the wafer cleaning station 13 (Fig. 2) or more general in one of or any of the wafer processing stations 12, 13, 14, 15 (Fig. 4) or the wafers 5 may be taken from the wafer receiving box 3 after the step of transporting 22 and placed in that processing station. In the latter case, the wafers 5 are preferably immersed in that processing station so that they are kept wet during the processing step.

In a preferred embodiment, during and/or subsequent to the step of cutting, a fluid flow 10 is generated in said fluid 9 of the wafer receiving box 3, preferably when the wafer receiving box 3 is still inserted in the wire saw 2 (Fig. 1) and/or during storage of the wafers 5 in the wafer receiving box 3 prior to a wafer processing step.

The fluid net flow 10 has a component which is transverse with respect to the moving direction of the ingot 4 through the wire web 18 of the wire saw 2 during the step of cutting. Preferably, the fluid net flow 10 is generated at least at the bottom 23 of the wafer receiving box 3 as can be seen from Fig. 1. The fluid net flow 10 is generated as to flow in the gaps between the wafers 5. In the embodiment of Fig. 1, the wafer receiving box 3 has an inlet 7 for introducing a fluid 9 into the wafer receiving box 3 and the fluid flow 10 is generated by introducing fluid 9 through the inlet 7 to the wafer receiving box 3. The inlet 7 is arranged in a side wall of the wafer receiving box 3. The wafer receiving box 3 has a closable outlet 8 for removing the fluid 9 from the wafer receiving box 3. The outlet 8 is arranged in a side wall or in the bottom wall of the wafer receiving box 3.

In the embodiment of Fig. 5, the bottom 23 of the wafer receiving box 3, at least when inserted in the wire saw 2, is inclined with respect to the horizontal. Alternatively to the embodiment of Fig. 5 the bottom 23 of the wafer receiving box 3 may be inclined in a direction perpendicular to the wire of the wire web (or parallel to the axes of the wire guide rollers supporting the wire web).

The fluid 9 in the wafer receiving box 3 is alkaline, preferably having a pH-value of pH > 7, preferably pH > 8, most preferably pH > 9.

As can be seen from Fig. 1, the wafer receiving box 3 comprises a clamping mechanism 11. Two movable holding members (double arrow in Fig. 1) laterally engage the wafers 5 when the cut is finished. The wafers 5 are clamped by the clamping mechanism 11 during the step of transporting 22.

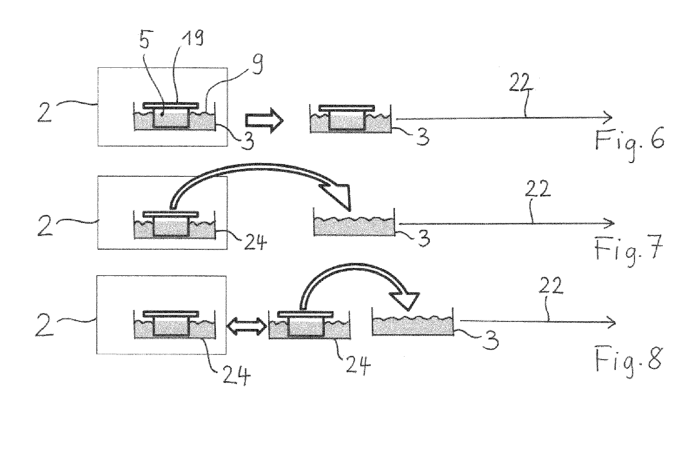

Fig. 6, 7 and 8 show different ways of how the wafers 5 are brought into the wafer receiving box 3 by means of which the wafers 5 are transported 22 to the subsequent processing station.

In the embodiment of Fig. 6 the wafers 5 are brought into the wafer receiving box 3 directly in the wire saw 2 by the downward movement of the wafers 5 during the cutting step. They are immersed, ideally completely filled (otherwise shown for clarity), in the fluid 9 of the wafer receiving box 3 and leave wire saw 2 within the wafer receiving box 3. The wafers 5 are immersed in the fluid 9 at least until they have reached the next processing station after the step of transporting 22.

In the embodiment of Fig. 7 the wafers 5 are received during the step of cutting in an intermediate wafer receiving box 24 which is filled with a fluid 9. However, the step of transporting 22 the wafers 5 to the processing station is not performed by means of this intermediate wafer receiving box 24. The wafers 5, e.g. still attached to the beam 19, are lifted out of said intermediate box 24 within the wire saw 2 and brought into a (transport) wafer receiving box 3 waiting outside the wire saw 2, preferably in its immediate vicinity. The transport 22 is performed by means of that (transport) wafer receiving box 3 which is filled with fluid 9.

In the embodiment of Fig. 8 the wafers 5 are received during the step of cutting in an intermediate wafer receiving box 24 which is filled with a fluid 9. The intermediate wafer receiving box 24 is pulled out of the wire saw 2. It is not necessary that the intermediate box 24 is completely detached from the wire saw 2. However, the step of transporting 22 the wafers 5 to the processing station is not performed by means of this intermediate wafer receiving box 24. The wafers 5 are lifted out of said intermediate box 24 outside of the wire saw 2 and brought into a (transport) wafer receiving box 3. The transport 22 is performed by means of that (transport) wafer receiving box 3 which is also filled with fluid 9.

In this embodiment it is not necessary that the intermediate box 24 is removably attached in the wafer saw 2. The intermediate box 4 is at least movably attached to the wire saw 2, such that the intermediate box 4 can be moved outside of the wire saw 2 without being detached.

In the embodiment of Fig. 8 the wafer carrier may be mounted to the wire saw like a drawer. Once the whole wafer brick is outside the wire saw 2, it is taken from the intermediate box 24 and placed - within one minute, preferably within 30 seconds or more preferably within 10 seconds in the wafer receiving box 3 by means of which the step of transporting 22 is performed.

Alternatively, to the embodiment of Fig. 8 the wafers 5 may be kept wet within the wire saw 2 during the step of cutting by means of fluid ejecting nozzles, by a static fluid basin and/or by a movable fluid basin.

In the methods shown in Figs. 7 and 8, the wafer brick may be retracted through the wire web or not. Whenever possible, the wafer brick may be retrieved from the wire saw from between the wire guide rollers (between the upper and lowe wire web) or from outside of the wire web. Even though a beam 19 is indicated in the figs 6 to 8, the wafers 5 may not be attached to a beam or be attached only to part of the initial beam (that may e.g. have been split in horizontal direction in the wire saw) or the complete beam may be used.

The invention is not restricted to these embodiments. Other variants will be obvious for the person skilled in the art and are considered to lie within the scope of the invention as formulated in the following claims.

### List of reference marks

- 1: wafer making system
- 2: wire saw
- 3: wafer receiving box
- 4: ingot
- 5: wafers
- 6: ingot holding mechanism
- 7: inlet
- 8: outlet
- 9: fluid
- 10: fluid flow
- 11: clamping mechanism
- 12: wafer pre-cleaning station
- 13: wafer cleaning station
- 14: de-gluing station
- 15: wafer separating station
- 16: carriage
- 17: wire guide rollers
- 18: wire web
- 19: beam
- 20: fixture attachment
- 21: support base
- 22: step of transporting
- 23: bottom of the wafer receiving box 3
- 24: intermediate wafer receiving container

## Claims

1. Method of making wafers (5) from an ingot (4), the method comprising:
- a step of cutting the ingot (4) into a plurality of wafers (5) in a wire saw (2),
- a step of receiving the wafers (5) by a wafer receiving box (3) during or subsequent to the step of cutting,
- a step of transporting (22) the wafers (5) by means of the wafer receiving box (3) to at least one wafer processing station (12, 13, 14, 15) which is arranged outside of the wire saw (2),
- at least one wafer processing step which is performed in said wafer processing station (12, 13, 14, 15),
**characterized in that**
during the step of transporting (22) the wafers (5) to said wafer processing station (12, 13, 14, 15) the wafer receiving box (3) is at least partially filled with fluid (9), wherein the wafers (5) are at least partially, preferably completely, immersed in said fluid (9).

2. Method according to claim 1, **wherein** during the step of cutting the wafers (5), the wafer receiving box (3) is removably held in the wire saw (2) such that the wafers (5) are received by the wafer receiving box (3) during the step of cutting.

3. Method according to claim 2, **wherein** during the step of cutting the wafers (5), the wafer receiving box (3) is at least partially filled with said fluid (9), preferably a fluid used for cutting, such that the wafers (5) are immersed in fluid (9) during the step of cutting.

4. Method according to one of the preceding claims, **wherein** the wafers (5) are kept immersed in said fluid (9) at least until the wafer processing step is started in said wafer processing station (12, 13, 14, 15).

5. Method according to one of the preceding claims, **wherein** during and/or subsequent to the step of cutting, a fluid flow (10) is generated in said fluid (9) of the wafer receiving box (3), preferably when the wafer receiving box (3) is still inserted in the wire saw (2) and/or during storage of the wafers (5) in the wafer receiving box (3) prior to a wafer processing step.

6. Method according to claim 5, **wherein** the fluid net flow (10) has a component which is transverse with respect to the moving direction of the ingot (4) through the wire web (18) of the wire saw (2) during the step of cutting, **wherein** preferably the fluid net flow (10) is generated at least near the bottom (23) of the wafer receiving box (3), **and/or wherein** the fluid net flow (10) is preferably generated as to flow in the gaps between the wafers (5).

7. Method according to one of the claims 5 to 6, **wherein** the wafer receiving box (3) has at least one inlet (7) for introducing a fluid (9) into the wafer receiving box (3) and wherein the fluid flow (10) is generated by introducing fluid (9) through the inlet (7) to the wafer receiving box (3) and wherein preferably the inlet (7) is arranged in a side wall of the wafer receiving box (3).

8. Method according to one of the preceding claims, **wherein** the wafer receiving box (3) has at least one closable outlet (8) for removing the fluid (9) from the wafer receiving box (3) and wherein preferably the outlet (8) is arranged in a side wall or in the bottom wall of the wafer receiving box (3).

9. Method according to one of the claims 5 to 8, **wherein** the bottom (23) of the wafer receiving box (3), at least when the fluid flow is generated, is inclined with respect to the horizontal.

10. Method according to one of the preceding claims, **wherein** the fluid (9) in the wafer receiving box (3) is alkaline, preferably having a pH-value of pH > 7, preferably pH > 8, most preferably pH > 9.

11. Method according to one of the preceding claims, **wherein** the wafer receiving box (3) comprises a clamping mechanism (11) and wherein the wafers (5) being clamped by the clamping mechanism (11) before or during the step of transporting (22).

12. Method according to one of the preceding claims, **wherein** the wafer processing station is selected from the group consisting of a wafer pre-cleaning station (12), a wafer cleaning station (13), a wafer de-gluing station (14) for de-gluing the wafers (5) from the beam (19) or removing glue from the wafers (5), a wafer separating station (15), a wafer texturization station for texturizing the surface of the wafers (5), or any combination thereof.

13. Method according to one of the preceding claims, **wherein** the method comprises at least two wafer processing steps each being performed in a separate wafer processing station (12, 13, 14, 15) and wherein one of the wafer processing steps is a separating step for separating the wafers (5) from each other and wherein the wafers (5) are kept immersed in said fluid (9) at least until the separating step is started.

14. Method according to one of the preceding claims, **wherein** during the step of cutting, the wafers (5) are received within the wire saw (2) by an intermediate wafer receiving box (24) and wherein the method comprises subsequent to the step of cutting a step of transferring the wafers (5) from the intermediate wafer receiving box (24) to the wafer receiving box (3) by means of which the step of transporting (22) the wafers (5) to at least one wafer processing station (12, 13, 14, 15) is performed, wherein preferably the intermediate wafer receiving box (24) is filled with fluid (9)

15. Method according to claim 14, **wherein** prior to the step of transferring the wafers (5) from the intermediate box (24) to the wafer receiving box (3) the intermediate wafer receiving box (24) is moved outside of the wire saw (2), wherein preferably the intermediate wafer receiving box (24) is movably mounted to the wire saw (2), preferably as a drawer.
